# EUROPEAN PATENT SPECIFICATION

(11) **EP 0 571 963 B1**
(45) Date of publication and mention of the grant of the patent: **26.08.1998**
(21) Application number: 93108451.1
(22) Date of filing: 25.05.1993
(51) Int. Cl.: G01R 31/04, G01R 31/316

(54) **Method of connection testing electronic boards**
Verfahren zum Prüfen der Verbindungen elektronischer Karten
Procédé d'essai des connexions de cartes électroniques

(30) Priority: 29.05.1992 IT TO920463
(43) Date of publication of application: 01.12.1993
(73) Proprietor: SPEA S.r.l. Sistemi per l'Elettronica e l'Automazione, I-10088 Volpiano (IT)
(72) Inventor: Bonaria, Luciano, I-10088 Volpiano (IT)
(74) Representative: Cerbaro, Elena

(56) References cited:
- EP-A- 0 306 656
- EP-A- 0 439 922
- DE-C- 4 110 551
- ELECTRONIQUE, no.27, April 1993, PARIS FR pages 42 - 45 P.SCHWARTZ 'Le test structurel se fiabilise'

## Description

The present invention relates to a method of connection testing electronic boards.

For detecting errors made when assembling or soldering electronic components or integrated circuits to electronic boards, and which could jeopardize operation of the finished board, various test techniques are employed for detecting disconnected or short-circuited pins, inverted or missing components, or structural damage to the input/output stages.

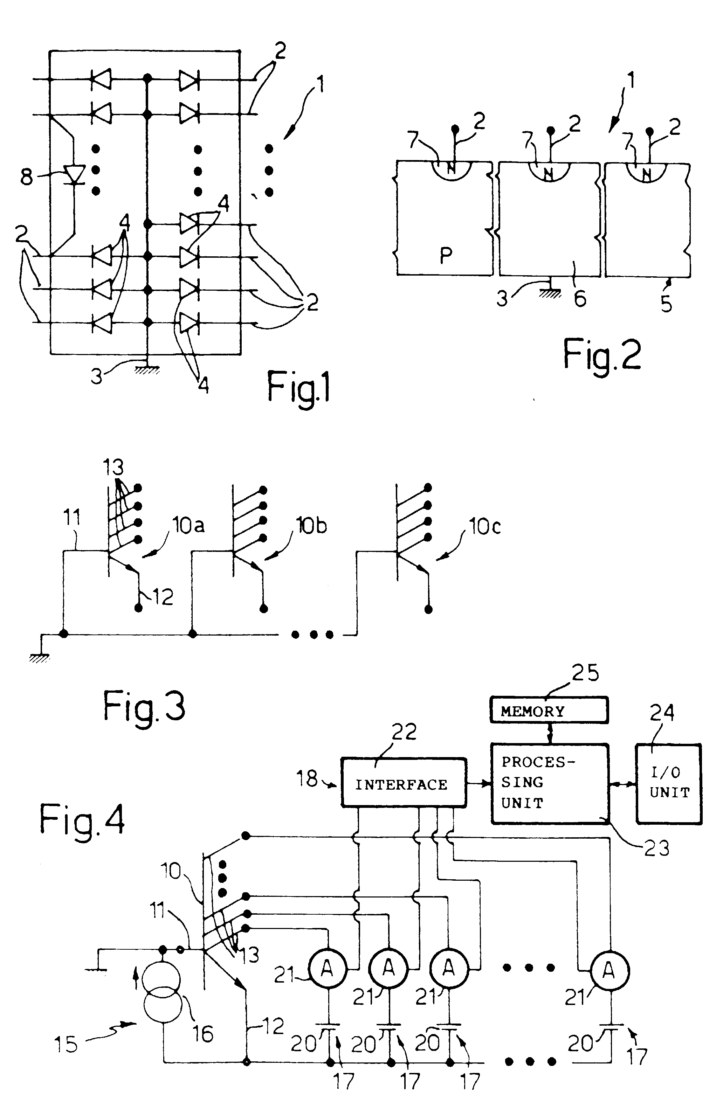

Such techniques are divided into "hot" and "cold" systems. In the first, the board is supplied by an external circuit for generating appropriate test signals, after which, the system determines, via beds of needles or similar, that the electric quantities measured correspond with predetermined values within a given tolerance. Systems of this sort, however, are highly complex and expensive due to the external supply circuit. Cold test systems, on the other hand, provide for testing the board disconnected from the voltage supply, and in this sense are more straightforward and economical. One such system employed in the past uses clamping diodes between the ground pin and the other pins on each integrated circuit, as shown by way of example in Fig.1, which shows a schematic view of an integrated circuit 1 having a number of pins 2, one of which, indicated by 3, is grounded; clamping diodes 4 between pins 2 and pin 3; and a clamping diode 8 between two pins 2.

Clamping diodes 4 are formed as shown in Fig.2, which shows a cross section of the chip 5 of integrated circuit 1. Fig.2, in which the circuit 1 component layers and sinkers are omitted, shows a P type substrate 6, and the N type sinkers 7 connected to pins 2 and which, together with substrate 6, form PN junctions defining clamping diodes 4.

The above known system therefore consists in appropriately biasing the clamping diodes and measuring the current through them for detecting any disconnected or short-circuited components.

Though straightforward in both design and operation, the above system has not always been found to be entirely dependable and for this reason has by now been more or less abandoned. The characteristics of diodes 4, in fact, are not always known and, at any rate, are not consistent, by virtue of depending closely on the type of external connection of the pins (more specifically, on whether they are connected to external buses or other pins on another integrated circuit) and also on the type of signal for which the pin is designed. As a result, absolute measurement of the current through each pin cannot always be depended on for determining correct connection.

EP-A-0 439 922 describes a testing system for testing the presence of proper conductive paths between the connector pins and the substrate exploiting parasitic lateral transistors formed by protection diodes. The system is based on biasing the parasitic transistor; waiting for stabilization; measuring the current flowing through the collector of a parasitic transistor after stabilization and the current flowing through the same collector after applying a current or voltage pulse, and comparing the two currents for detecting a fault in case of equal measured currents.

It is an object of the present invention to provide a connection test method of the second type, i.e. of straightforward design and circuitry, which nevertheless provides for a high degree of reliability, even in the case of integrated circuits whose internal structure is unknown.

According to the present invention, there is provided a method of testing the connections of electronic boards, as defined in claim 1.

A preferred, non-limiting embodiment of the present invention will be described by way of example with reference to the accompanying drawings, in which:
Fig.1 shows an equivalent diagram of an integrated circuit with clamping diodes;
Fig.2 shows a cross section of a chip in which the clamping diodes are formed;
Fig.3 shows a circuit diagram of the equivalent multicollector structures formed by the clamping diodes of an integrated circuit:
Fig.4 shows a circuit diagram of a measuring system in accordance with the present invention;
Fig.5 shows a flow chart of the method according to the present invention.

The present invention is based on the fact that, on integrated circuits of the above type, various structures are obtainable by appropriately grouping the clamping diodes, that is:
a diode structure consisting of a diode between the ground pin and each other pin, or between two different pins;
a transistor structure consisting of two diodes between the ground pin and two different pins (the transistors in fact consist more or less of two antiseries PN junctions);
a multiemitter structure consisting of the diodes between the ground pin and the other pins, and which present similar functional and connection characteristics;
a multicollector structure, as above;
an SCR structure consisting of two series diodes, one between ground and a first pin, and the other between the first pin and a second pin (if any) on the integrated circuit.

Examination of the above structures has shown the transistor and SCR structures to be affected by the same problems as the diode discussed earlier, whereas the multicollector or multiemitter structures can be used safely by virtue of the base-collector diodes (on the multicollector structure) being connected to pins having the same characteristics in terms of external connection and signal type. In fact, when current is injected between the base and a pin representing the emitter on the structure, the other pins function as collectors and, having the same functional and connection characteristics, tend to amplify the current accordingly. A marked difference in the collector currents thus indicates a faulty connection (short or disconnected circuits, wrong or ill-assembled components, damage to input/output stages).

Fig.3 shows an equivalent diagram of the clamping diodes in the Fig.1 circuit, grouped uniformly as described above according to the type of pin connection (bus or single component); the type of signals for which the pin is designed (e.g. analog, digital, address, data or control); and the level of the electric quantities involved. Each group thus defines a multicollector structure (Fig.3 shows three, 10a, 10b, 10c, respectively relative for example to bus-connected data, address and control signal pins) having its own base terminal 11 (grounded pin), its own emitter terminal 12 (one of the pins in the homogeneous group), and a number of collector terminals 13 (the other pins in the same group).

According to the present invention, each structure 10 is tested by biasing it, measuring the collector current at terminals 13, and checking that the difference in current (which is inevitable, due to production spread and an intrinsic amount of measuring inaccuracy) is below a given percentage of a given reference value.

For this purpose, each structure 10 is connected to a test apparatus 15 as shown in Fig.4. In the embodiment shown, apparatus 15 comprises a current source 16 connected between base terminal 11 and emitter terminal 12; a number of measuring branches 17 connected between emitter terminal 12 and respective collector terminals 13; and a processing logic circuit 18. More specifically, each measuring branch 17 comprises a series-connected voltage source 20 and ammeter 21; and logic circuit 18 comprises an interface 22 connected to ammeters 21 from which it receives the measuring result; a processing unit 23 connected to interface 22 and controlling the diagnostic stage; an input/output unit 24 connected to processing unit 23, for exchanging data, commands and information with the operator or an external system; and a data memory 25.

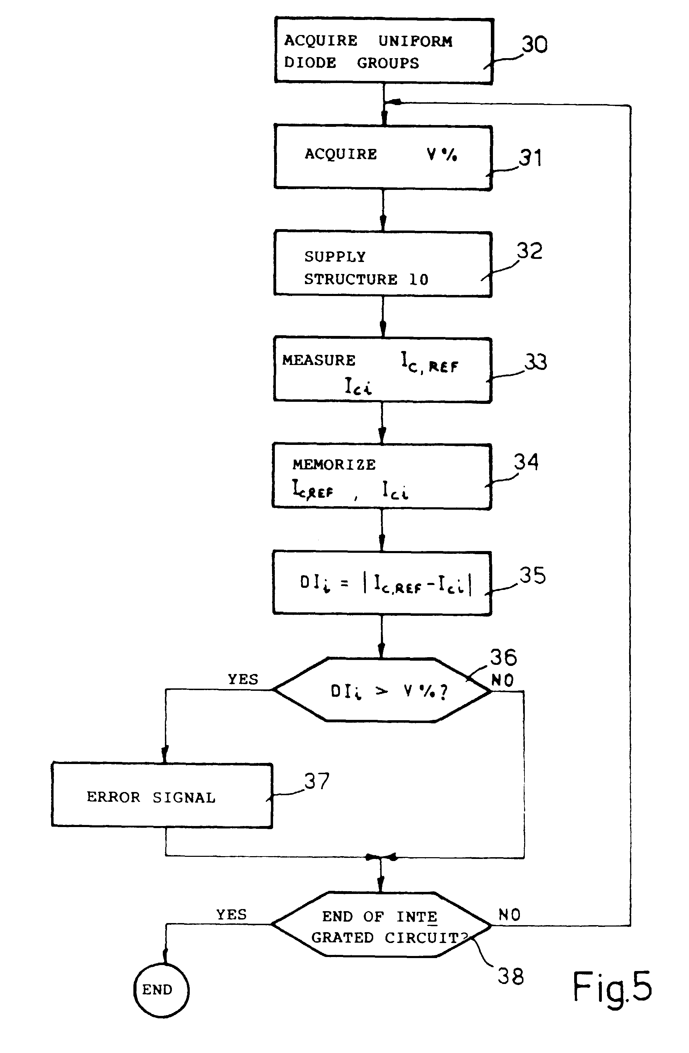

Fig.5 shows a flow chart of the various stages whereby each integrated circuit is tested according to the present system.

To begin with, block 30 provides for acquiring information relative to the diodes grouped uniformly as described above, i.e. connected to similarly connected pins designed for the same type of signal or electric quantity. This may be done by the operator entering the above data on input/output unit 24, or by reading memory 25, if the data has already been entered and stored for similar integrated circuits.

In the same way, block 31 then provides for acquiring the permitted percentage deviation of the collector currents in the diodes of the same group, which deviation is selected, for example, on the basis of the absolute value of the measured collector current and/or predictable spread according to the technology of the integrated circuit in question, as well as the type of pin connection and signal.

Block 32 then provides for enabling current source 16 and sources 20; and block 33 for acquiring, via interface 22, the I_{Ci} current values measured by ammeters 21 and produced by amplifying the base current injected by source 16, and one of which constitutes reference value I_{C,REF} with which the other collector currents are compared. The currents so detected are then memorized in block 34 and subsequently compared with one another. More specifically, for all the detected I_{C} values, block 35 provides for calculating the difference DIᵢ between the i-thy current I_{Ci} and reference current I_{C,REF}, and block 36 for checking the differences are below the set deviation percentage V%. If they are not (collector currents below the minimum threshold or above the maximum threshold - YES output of block 36), an error signal is generated by block 37, possibly also indicating the faulty pin and the type of fault detected, after which, block 38 checks that all the homogeneous groups on the circuit have been tested. Block 38 is also reached in the event of the connections testing out correctly (NO output of block 36). When all the multicollector structures 10 on circuit 1 have been tested (YES output of block 38), the procedure is terminated (or repeated for other circuits on the same board). Conversely (NO output of block 38), block 38 goes back to block 31.

The advantages of the present invention will be clear from the foregoing description.

In particular, it provides for a straightforward, highly reliable method of connection testing integrated circuit pins, by virtue of the collector currents, in the event of correct connection, being comparable and varying within predetermined limits depending on the connection and operating characteristics of the pin, and regardless of the absolute value detected. Moreover, said absolute value need not necessarily be known beforehand, so that the test may also be applied to integrated circuits of unknown function, and of which are known only the connections and the type and level of the electric quantities involved, as shown on any integrated circuit data sheet. In the case of integrated circuits of known type and known integrated components, the homogeneous diode groups constituting the multicollector structures may be acquired automatically; and the procedure described may be implemented in and form only part of a much wider test system.

Finally, the system according to the present invention is straightforward as regards both design and circuitry, and as such may be implemented easily and relatively cheaply.

To those skilled in the art it will be clear that changes may be made to the method as described and illustrated herein, in particular for adapting it to specific requirements, without, however, departing from the scope of the present invention. For example, instead of being measured simultaneously for all the collector-base diodes in the same group, collector currents I_{Ci} may be measured sequentially, thus drastically simplifying apparatus 15 by reducing it to a single measuring branch 17, as well as interface unit 22 for acquiring the detected measurements.

The system may also provide for additional checks, e.g. for detecting faulty connection of the reference base-collector diode or base-emitter diode.

The collector currents may also be compared differently, by calculating a mean detected current value and comparing each collector current value with the mean value instead of a reference value. Also, the mean value or deviation may be calculated using various techniques as required.

## Claims

1. A method of testing the connections of electronic boards comprising integrated circuits (1) having pins (2, 3) and clamping diodes (4, 8) between said pins, characterized by the steps of:
identifying (30) uniform groups of said diodes (4, 8) on the basis of functional or structural characteristics, for identifying at least a structure (10) having a plurality of uniform characteristic terminals;
biasing (32) said structure (10) so as to cause currents (I_{Ci}) to flow through said plurality of uniform characteristic terminals of said identified structure;
measuring (33) said currents at said plurality of uniform characteristic terminals of said structure;
comparing (35, 36) said measured currents with each other; and
detecting (36, 37) any faulty connections on the basis of a marked variation in said measured currents.

2. A method according to claim 1, characterized in that said structure consists of a multicollector transistor (10) and in that said biasing step (32) comprises the step of supplying a bias current to a ground pin (3) of an integrated circuit (1), and applying a voltage difference between the emitter terminal and the collector terminals of said structure (10).

3. A method according to claim 1 or 2, characterized in that said comparing step (35, 36) comprises the steps of selecting a reference terminal among said uniform characteristic terminals and comparing the current (I_{C,REF}) through said reference terminal with the currents (I_{Ci}) at the other uniform characteristic terminals.

4. A method according to claim 1 or 2, characterized in that said comparing step (35, 36) comprises the steps of determining the mean value of the currents through said uniform characteristic terminals and comparing said measured currents with said mean value.

5. A method according to any one of claims 1-4, characterized in that said measuring step (33) is performed simultaneously for all said uniform characteristic terminals.

6. A method according to any one of claims 1-4, characterized in that said measuring step (33) is performed sequentially, one uniform characteristic terminal at a time.

7. A method according any one of the claims 1-5, characterized in that said comparing step comprises the step of calculating (35) the difference (DIi) between a reference value (I_{C,REF}) and said measured values (I_{Ci}); and in that said faulty connection detecting step comprises the steps of determining (31) a permissible deviation (V%), comparing (36) said deviation with said difference, and generating (37) a faulty connection signal in the event said difference exceeds said deviation.

8. A method according to any one of claims 1-7, characterized in that said uniform group identifying step (30) consists in grouping the pins (2, 3) on said integrated circuit according to the type of connection to other components and structures on the board, the type of signals exchanged and the level of the electric quantities involved.

9. A system for testing the connections of electronic boards comprising integrated circuits (1) with pins (2, 3) and clamping diodes (4, 8) between said pins; characterized in that it comprises means (30) for identifying uniform groups of said diodes on the basis of functional or structural characteristics and so identifying at least one structure having a plurality of uniform characteristic terminals; means (16, 20) for biasing said structure (10) so as to cause currents (I_{Ci}) to flow through said uniform characteristic terminals (13); means (21) for measuring said currents at said uniform characteristic terminals; means (36) for comparing said measured currents; and means for detecting faulty connections on the basis of marked variations in said currents.

## Patentansprüche

1. Verfahren zum Prüfen der Verbindungen von elektronischen Platinen mit integrierten Schaltkreisen (1) mit Pins (2, 3) und Klemmdioden (4, 8) zwischen den Pins, gekennzeichnet durch die folgenden Schritte:
Identifizieren (30) von einheitlichen Gruppen der Dioden (4, 8) auf der Basis von funktionalen oder strukturellen Charakteristiken zum Identifizieren mindestens einer Struktur (10) mit einer Mehrzahl von einheitlichen charakteristischen Anschlüssen;
Vorspannen (32) der Struktur (10), um zu bewirken, daß Ströme (I_{Ci}) durch die Mehrzahl von einheitlichen charakteristischen Anschlüssen der identifizierten Struktur fließen;
Messen (33) der Ströme an der genannten Mehrzahl von einheitlichen charakteristischen Anschlüssen der Struktur;
Vergleichen (35, 36) der gemessenen Ströme miteinander; und
Detektieren (36, 37) jeglicher fehlerhaften Verbindungen auf der Basis einer deutlichen Variation bei den gemessenen Strömen.

2. Verfahren nach Anspruch 1, dadurch gekennzeichnet, daß die Struktur aus einem Multikollektor-Transistor (10) besteht und daß der Vorspann-Schritt (32) den Schritt des Zuführens eines Vorspannstromes an einen Massepin (3) eines integrierten Schaltkreises (1) und das Anlegen eines Spannungsunterschieds zwischen dem Emitteranschluß und den Kollektoranschlüssen der Struktur (10) umfaßt.

3. Verfahren nach Anspruch 1 oder 2, dadurch gekennzeichnet, daß der Vergleichsschritt (35, 36) die folgenden Schritte aufweist: Auswählen eines Referenzanschlusses unter den einheitlichen charakteristischen Anschlüssen und Vergleichen des Stromes (I_{C,REF}) durch den Referenzanschluß mit den Strömen (I_{Ci}) an den anderen einheitlichen charakteristischen Anschlüssen.

4. Verfahren nach Anspruch 1 oder 2, dadurch gekennzeichnet, daß der Vergleichsschritt (35, 36) die folgenden Schritte aufweist: Feststellen des Mittelwerts der Ströme durch die einheitlichen charakteristischen Anschlüsse und Vergleichen der gemessenen Ströme mit dem Mittelwert.

5. Verfahren nach einem der Ansprüche 1 bis 4, dadurch gekennzeichnet, daß der Meßschritt (33) gleichzeitig für alle genannten einheitlichen charakteristischen Anschlüsse ausgeführt wird.

6. Verfahren nach einem der Ansprüche 1 bis 4, dadurch gekennzeichnet, daß der Meßschritt (33) nacheinander einzeln für jeden einheitlichen charakteristischen Anschluß ausgeführt wird.

7. Verfahren nach einem der Ansprüche 1 bis 5, dadurch gekennzeichnet, daß der Vergleichsschritt den Schritt des Berechnens (35) des Unterschieds (DIᵢ) zwischen einem Referenzwert (I_{C,REF}) und den gemessenen Werten (I_{Ci}) aufweist; und daß der Schritt des Detektierens einer fehlerhaften Verbindung die folgenden Schritte aufweist: Feststellen (31) einer zulässigen Abweichung (V%), Vergleichen (36) der Abweichung mit der Differenz und Erzeugen (37) eines Fehlerhafte-Verbindung-Signals, falls die Differenz die Abweichung überschreitet.

8. Verfahren nach einem der Ansprüche 1 bis 7, dadurch gekennzeichnet, daß der einheitliche Gruppen identifizierende Schritt (30) aus einem Gruppieren der Pins (2, 3) an dem integrierten Schaltkreis gemäß der Art der Verbindung mit anderen Komponenten und Strukturen auf der Platine, der Art von ausgetauschten Signalen und dem Niveau der betreffenden elektrischen Größen besteht.

9. System zum Prüfen der Verbindungen von elektronischen Platinen mit integrierten Schaltkreisen (1) mit Pins (2, 3) und Klemmdioden (4, 8) zwischen den Pins; dadurch gekennzeichnet, daß es aufweist: eine Einrichtung (30) zum Identifizieren einheitlicher Gruppen der Dioden auf der Basis von funktionalen oder strukturellen Charakteristiken und dadurch Identifizieren mindestens einer Struktur mit einer Mehrzahl von einheitlichen charakteristischen Anschlüssen; eine Einrichtung (16, 20) zum Vorspannen der Struktur (10), um zu bewirken, daß Ströme (I_{Ci}) durch die einheitlichen charakteristischen Anschlüsse (13) fließen; eine Einrichtung (21) zum Messen der Ströme an den einheitlichen charakteristischen Anschlüssen; eine Einrichtung (36) zum Vergleichen der gemessenen Ströme und eine Einrichtung zum Detektieren fehlerhafter Verbindungen auf der Basis von deutlichen Variationen der Ströme.

## Revendications

1. Procédé d'essai des connexions de cartes électroniques comprenant des circuits intégrés (1) comportant des broches (2, 3) et des diodes de fixation de niveau (4, 8) entre lesdites broches, caractérisé par les étapes consistant à :
identifier (30) des regroupements uniformes desdites diodes (4, 8) sur la base des caractéristiques fonctionnelles ou structurelles, afin d'identifier au moins une structure (10) comportant une pluralité de bornes à caractéristiques uniformes,
polariser (32) ladite structure (10) de façon à amener des courants (Ici) à circuler au travers de ladite pluralité de bornes à caractéristiques uniformes de ladite structure identifiée,
mesurer (33) lesdits courants au niveau de ladite pluralité de bornes à caractéristiques uniformes de ladite structure,
comparer (35, 36) lesdits courants mesurés les uns aux autres, et
détecter (36, 37) toutes connexions défectueuses sur la base d'une variation marquée desdits courants de mesure.

2. Procédé selon la revendication 1, caractérisé en ce que ladite structure est constituée d'un transistor à collecteurs multiples (10) et en ce que ladite étape de polarisation (32) comprend l'étape consistant à appliquer un courant de polarisation à une broche de masse (3) d'un circuit intégré (1), et à appliquer une différence de tension entre la borne d'émetteur et les bornes de collecteurs de ladite structure (10).

3. Procédé selon la revendication 1 ou 2, caractérisé en ce que ladite étape de comparaison (35, 36) comprend les étapes consistant à sélectionner une borne de référence parmi lesdites bornes à caractéristiques uniformes et à comparer le courant (I_{C,REF}) circulant dans ladite borne de référence aux courants (Ici) au niveau des autres bornes à caractéristiques uniformes.

4. Procédé selon la revendication 1 ou 2, caractérisé en ce que ladite étape de comparaison (35, 36) comprend les étapes consistant à déterminer la valeur moyenne des courants circulant dans lesdites bornes à caractéristiques uniformes et à comparer lesdits courants mesurés à ladite valeur moyenne.

5. Procédé selon l'une quelconque des revendications 1 à 4, caractérisé en ce que ladite étape de mesure (33) est exécutée simultanément pour toutes lesdites bornes à caractéristiques uniformes.

6. Procédé selon l'une quelconque des revendications 1 à 4, caractérisé en ce que ladite étape de mesure (33) est exécutée séquentiellement pour une borne à caractéristique uniforme à la fois.

7. Procédé selon l'une quelconque des revendications 1 à 5, caractérisé en ce que ladite étape de comparaison comprend l'étape consistant à calculer (35) la différence (DIᵢ) entre une valeur de référence (I_{C,REF}) et lesdites valeurs mesurées (I_{Ci}), et en ce que ladite étape de détection de connexion défectueuse comprend les étapes consistant à déterminer (31) un écart autorisable (V%), à comparer (36) ledit écart à ladite différence, et à générer (37) un signal de connexion défectueuse dans le cas où ladite différence dépasse ledit écart.

8. Procédé selon l'une quelconque des revendications 1 à 7, caractérisé en ce que ladite étape d'identification de regroupement uniforme (30) consiste en un regroupement des broches (2, 3) sur ledit circuit intégré conformément au type de connexion, vers d'autres composants et structures sur la carte, au type des signaux échangés et au niveau des valeurs électriques impliquées.

9. Système destiné à essayer les connexions de cartes électroniques comprenant des circuits intégrés (1) avec des broches (2, 3) et des diodes de fixation de niveau (4, 8) entre lesdites broches, caractérisé en ce qu'il comprend un moyen (30) destiné à identifier des groupements uniformes desdites diodes sur la base de caractéristiques fonctionnelles ou structurelles et d'identifier ainsi au moins une structure comportant une pluralité de bornes à caractéristiques uniformes, un moyen (16, 20) destiné à polariser ladite structure (10) de façon à amener des courants (Ici) à circuler au travers desdites bornes à caractéristiques uniformes (13), un moyen (21) destiné à mesurer lesdits courants au niveau desdites bornes à caractéristiques uniformes, un moyen (36) destiné à comparer lesdits courants mesurés, et un moyen destiné à détecter les composants défectueux sur la base des variations marquées desdits courants.
